Europäisches Patentamt

European Patent Office

Office européen des brevets

(11) Numéro de publication: **0 373 006**
**A1**

## (12) DEMANDE DE BREVET EUROPEEN

(21) Numéro de dépôt: 89400039.7

(22) Date de dépôt: 06.01.89

(51) Int. Cl.5: **H05K 7/18**

(30) Priorité: 06.12.88 FR 8816410

(43) Date de publication de la demande:
13.06.90 Bulletin 90/24

(84) Etats contractants désignés:
AT BE CH DE ES GB GR IT LI LU NL SE

(71) Demandeur: SOCIETE INDUSTRIELLE
D'ELECTRO MECANIQUE - S.I.E.M., Société
Anonyme dite :
5, rue du Leughenaer
F-59140 Dunkerque(FR)

(72) Inventeur: Ayello, Louis
13, route d'Esquelbecq Socx
F-59380 Bergues(FR)

(74) Mandataire: Lepage, Jean-Pierre
Cabinet Lemoine & Associés 12, Boulevard
de la Liberté
F-59800 Lille(FR)

(54) Armoire étanche pour matériel électrique.

(57) L'invention est relative à une armoire étanche destinée notamment à contenir du matériel électrique et à le protéger contre une immersion

L'armoire (1) comprend un coffre (2) fermé par une ou plusieurs portes (3 et 4) articulées autour de charnières (5) et munies de moyens d'étanchéité (12) périphérique. Selon l'invention, l'armoire (1) comporte un double dispositif de fermeture (8 et 9) disposé le long des chants latéraux de chacune des portes (3 et 4) qui coopère avec des points d'accrochage (7) répartis autour des ouvertures de porte sur l'armoire (1). Le double dispositif se présente sous la forme de deux crémones (13 et 14) fixées le long des chants latéraux sur lesquelles sont régulièrement disposés des taquets (15) coopérant avec des crochets (7) fixés au coffre (2).

L'invention concerne le matériel électrique utilisé dans un environnement à risque d'innondation.

Fig. 2

L'invention est relative à une armoire étanche destinée notamment à contenir du matériel électrique et à le protéger contre une immersion. Elle trouvera en particulier son application dans le domaine de l'équipement maritime, militaire ou à haut risque d'innondation.

Le fonctionnement de nombreux matériels est totalement perturbé en présence d'humidité, c'est le cas notamment de l'appareillage électrique et électronique. Aussi, lorsque ces équipements sont installés dans un environnement hostile ou à risque, il est nécessaire de les placer dans une armoire étanche.

Il existe de nombreux types d'armoires étanches dont la construction et la technologie dépendent du degré d'étanchéité recherché.

Une étanchéité élémentaire doit résister aux projections d'eau. La technologie utilisée actuellement pour atteindre cet objectif consiste à placer sur la périphérie de l'ouverture de porte un joint élastique de mousse qui coopère avec une arête vive venant pénétrer dans la mousse pour faire obstacle au passage de l'eau. Cette technique offre l'avantage de la simplicité mais la durée de vie du joint est limitée étant donné qu'il a tendance à se couper avec la pénétration de l'arête vive.

Pour le matériel embarqué ou présentant un risque d'immersion, on peut se satisfaire de cette solution d'autant plus que l'on n'est pas assuré de la répartition de l'effort de fermeture sur toute la longueur du joint. Il s'agit là d'ailleurs d'une notion fondamentale en matière d'étanchéité. L'effort de fermeture doit être réparti sur toute la périphérie de l'ouvrant afin que le joint d'étanchéité soit régulièrement comprimé. Avec les dispositifs de fermeture de porte ordinaires, on rencontre bien souvent un point ou deux points seulement d'accrochage et de mise en pression du joint du dispositif de fermeture et cela est insuffisant. Il faut en effet prendre en considération les fléchissements de la porte généralement en tôle et pour garantir une pression minimum dans les zones les plus éloignées des dispositifs d'accrochage, il faudrait faire régner une pression d'appui considérable au niveau des points de fixation.

Pour résoudre ce problème, il existe différentes solutions. La plus classique consiste à utiliser différentes fermetures réparties tout autour de l'ouvrant, qui se présentent sous la forme de tiges filetées articulées sur lesquelles est enfilé un écrou papillon qui vient coopérer avec une fente ouverte solidaire de la porte. Ce type de fermeture donne satisfaction sur le plan de l'étanchéité pour les coffrets mais il est très long à ouvrir et fermer car les dispositifs à vis - écrou demandent une manoeuvre individuelle. De plus, il ne peut être installé que sur des armoires ayant une seule porte d'accès puisque le dispositif se fixe sur le côté de l'armoire et ne pourrait être installé dans la partie centrale de la face avant.

On connaît aussi les systèmes de verrouillage rencontrés sur les portes de sous marins qui comportent une série de barres radiales de verrouillage manoeuvrées par un mécanisme central. Il s'agit toutefois d'un équipement lourd mal adapté aux armoires étant donné qu'il requiert des points d'ancrage répartis autour de la porte, ce qui limite la surface de celle-ci.

Parmi les solutions plus sophistiquées, on rencontre également le joint d'étanchéité gonflable qui se présente sous la forme d'une chambre à air comprimé après la fermeture de la porte. L'étanchéité est bonne et l'on est assuré de la bonne répartition de la pression. Il faut toutefois disposer d'une source d'air comprimé ce qui limite son utilisation.

Il existe également les coffrets pressurisés dont la pression intérieure est ajustée de telle sorte qu'elle soit toujours légèrement supérieure à la pression extérieure. Ainsi, on est assuré que les fuites se feront toujours depuis l'intérieur du coffret vers l'extérieur. Il n'y a pas, à proprement parler, étanchéité mais une assurance de préserver le matériel vis-à-vis de toute introduction de liquide. Cette technologie très avancée demande un système automatique de commande fonctionnant à partir de capteurs de pression et d'une source d'air comprimé extrêmement onéreux.

Le but principal de la présente invention est de présenter une armoire étanche susceptible de résister à une immersion , en particulier l'objectif recherché est une résistance à toute pénétration d'eau à l'issue d'une plongée sous un mètre d'eau au-dessus de l'armoire pendant 48 heures au moins. L'armoire étanche de l'invention comprend un dispositif d'ouverture rapide et peut comporter une ou plusieurs portes frontales.

La technologie utilisée pour la construction de l'armoire étanche de l'invention relève de la tôlerie traditionnelle et ne requiert aucun outillage spécialisé. Les coûts de fabrication sont très compétitifs et la facilité de la manoeuvre apporte un progrès certain vis-à-vis de la technologie vis - écrou actuellement employée.

Une attention particulière a été apportée pour assurer une longévité accrue du joint d'étanchéité qui n'a pas à souffrir du contact d'une arête vive.

Selon la technique préconisée, l'ouverture et la fermeture d'une porte sont assurées par la simple rotation de deux poignées. Ceci permet une manoeuvre très rapide et par ailleurs, on est assuré de l'effort de fermeture régulièrement réparti.

D'autres buts et avantages de la présente invention apparaîtront au cours de la description qui va suivre qui n'est cependant donnée qu'à titre indicatif et qui n'a pas pour but de la limiter.

L'armoire étanche, destinée notamment à contenir du matériel électrique et à le protéger contre une immersion, qui comprend un coffre fermé par une ou plusieurs portes articulées autour de charnières et munies de moyens d'étanchéité périphérique, est caractérisée par le fait qu'elle comporte un double dispositif de fermeture disposé le long des chants latéraux de chacune des portes, qui coopère avec des points d'accrochage répartis autour des ouvertures de porte sur l'armoire.

L'invention sera mieux comprise à la lecture de la description suivante accompagnée de dessins en annexe parmi lesquels :

- la figure 1 représente un exemple d'armoire étanche en vue de face selon la présente invention,

- la figure 2 représente l'armoire étanche avec une porte ouverte,

- la figure 3 schématise le principe de fonctionnement du dispositif de fermeture de la porte,

- la figure 4 montre en vue de coupe le système d'étanchéité ainsi que des détails de construction particulière de la charnière.

La présente invention vise une armoire étanche destinée notamment à contenir du matériel électrique et à le protéger contre une immersion. Elle trouvera notamment son application dans le domaine maritime, militaire ou plus généralement en présence d'un milieu à risque d'innondation.

Dans l'exemple choisi pour illustrer l'invention, l'armoire étanche a été conçue pour protéger un appareillage de commande. L'objectif visé est une résistance à toute pénétration d'eau pendant 48 heures sous un mètre d'eau.

Traditionnellement, pour obtenir une étanchéité, les constructeurs utilisent un joint élastique de mousse qui travaille avec une arête vive pour obtenir une forte pression de contact local. Cette technique ne donne malheureusement pas satisfaction à l'usage étant donné que le joint en mousse finit par se déchirer sous l'action de l'arête vive.

Dans les systèmes d'étanchéité à contact plus large, il est nécessaire de disposer d'une force d'appui régulièrement répartie sur toute la longueur du joint. Ceci peut être obtenu en utilisant par exemple les mécanismes de fermeture type vis articulée, écrou à oreilles, passés à travers une fente solidaire de l'ouvrant. Cependant, ce type de fermeture est très long à manoeuvrer et il n'est pas facile à mettre en oeuvre lorsque plusieurs portes sont mises en place sur une même armoire.

Parmi les systèmes plus sophistiqués, il existe le joint gonflable, l'armoire pressurisée ou le verrou à barres multiples. Ces réalisations sont cependant réservées à des applications très spécifiques étant économiquement très chères.

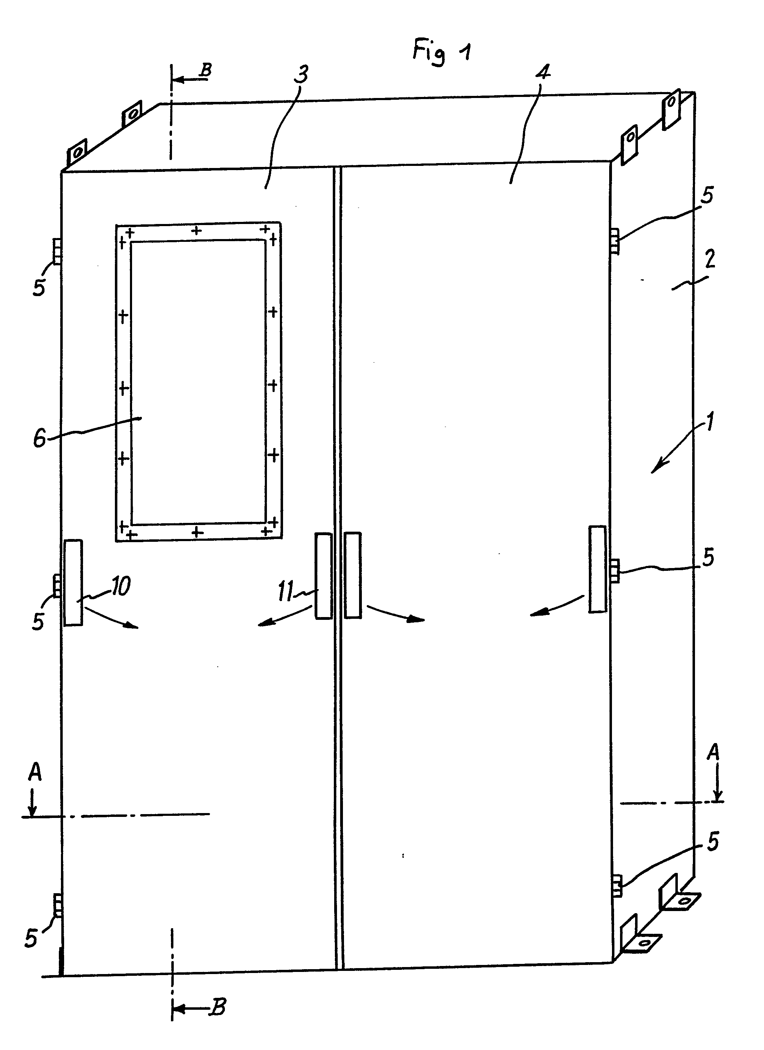

Un exemple de réalisation d'armoire étanche selon la présente invention est illustré à la figure 1.

L'armoire (1) comprend un coffre (2), ici fermé par deux portes (3 et 4) articulées autour de charnières (5) afin de donner un libre accès au contenu du coffre (2). A titre d'exemple, l'une des portes (3) est munie d'un hublot (6) qui autorise une vision interne du contenu de l'armoire (1). La réalisation illustrée ici présente une largeur de 1 mètre pour une hauteur de 1,45 mètre et une profondeur de 0,40 mètre. Ces dimensions sont données à titre indicatif.

Bien entendu, l'étanchéité de l'armoire n'est pas seulement localisée au niveau des ouvertures de porte mais également aux endroits de passage des câbles grâce à des presses étoupes spécialement réalisées et connues de l'Homme de l'Art.

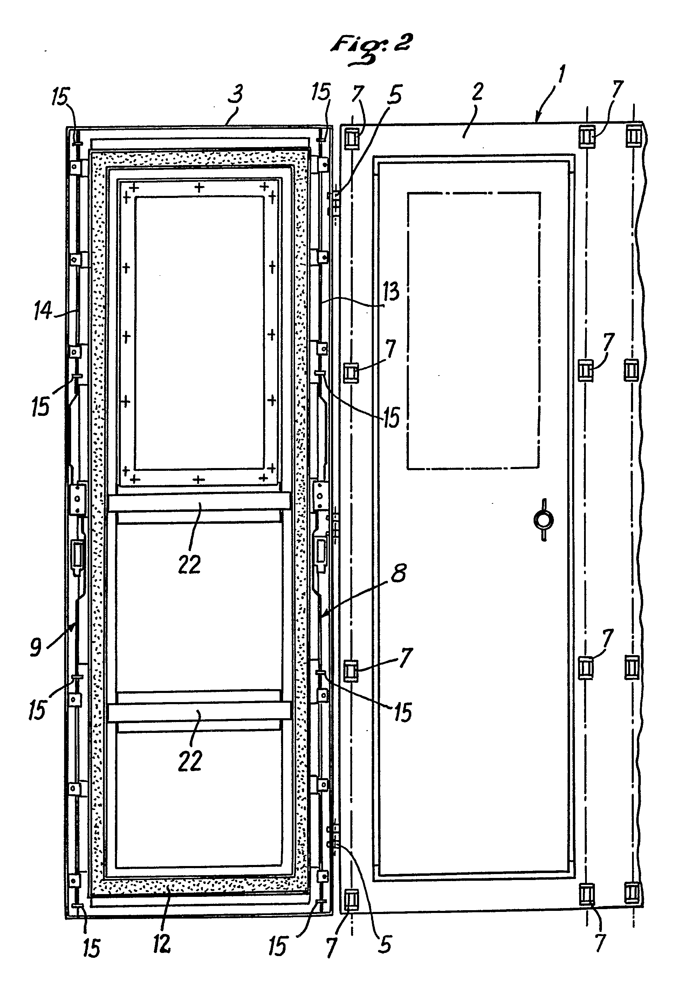

Selon l'invention, l'armoire étanche (1) comporte un double dispositif de fermeture disposé le long des chants latéraux de chacune des portes (3 et 4) qui coopèrent avec des points d'accrochage (7) répartis autour des ouvertures de porte sur l'armoire (1). La figure 2 représente l'armoire (1) avec la porte (3) ouverte pour illustrer la présence des dispositifs de fermeture (8 et 9) installés le long des côtés latéraux de la porte (3). La manoeuvre des dispositifs de fermeture (8 et 9) telle qu'envisagée est indépendante, toutefois l'Homme de l'Art pourra très facilement les jumeler à l'aide d'une tringlerie appropriée. Le bénéfice de cette liaison n'est pas élevé étant donné que la manoeuvre de chacun des dispositifs de fermeture (8 et 9) est assurée à l'aide d'une poignée frontale (10 et 11) telle qu'illustrée à la figure 1 manoeuvrée par simple rotation.

Les dispositifs de fermeture (8 et 9) sont disposés à l'extérieur du joint d'étanchéité (12) de la porte (3), ce qui permet de s'affranchir de tout problème d'étanchéité au niveau des passages de poignées de commande (10 et 11).

Il faut remarquer que la porte (3) est plaquée contre le coffre (2) de l'armoire (1) également le long du côté portant les charnières (5). Pour que le dispositif de fermeture (8) puisse également assurer toute son efficacité, il est indispensable que les charnières (5) puissent supporter le déplacement correspondant. Précisément, une description de ce type de charnière est donnée par la suite.

Selon l'invention, le double dispositif (8 et 9) de fermeture se présente sous la forme de deux crémones (13 et 14) fixées le long des chants latéraux de la porte, sur lesquels sont régulièrement disposés des moyens d'accrochage au coffre (2). Ces moyens d'accrochage d'ailleurs se présentent sous la forme de taquets (15) qui coopèrent avec des crochets (7) fixés sur le coffre . Le principe de fermeture par crémone est connu avec toutefois une limitation à deux points d'ancrage. Ici, la crémone comporte sur toute sa longueur différents taquets (15) qui coopèrent avec des crochets (7) afin de répartir régulièrement l'effort. De plus, l'une des crémones (13) est située du côté des charnières (5) pour également assurer une répartition de l'effort de fermeture à ce niveau.

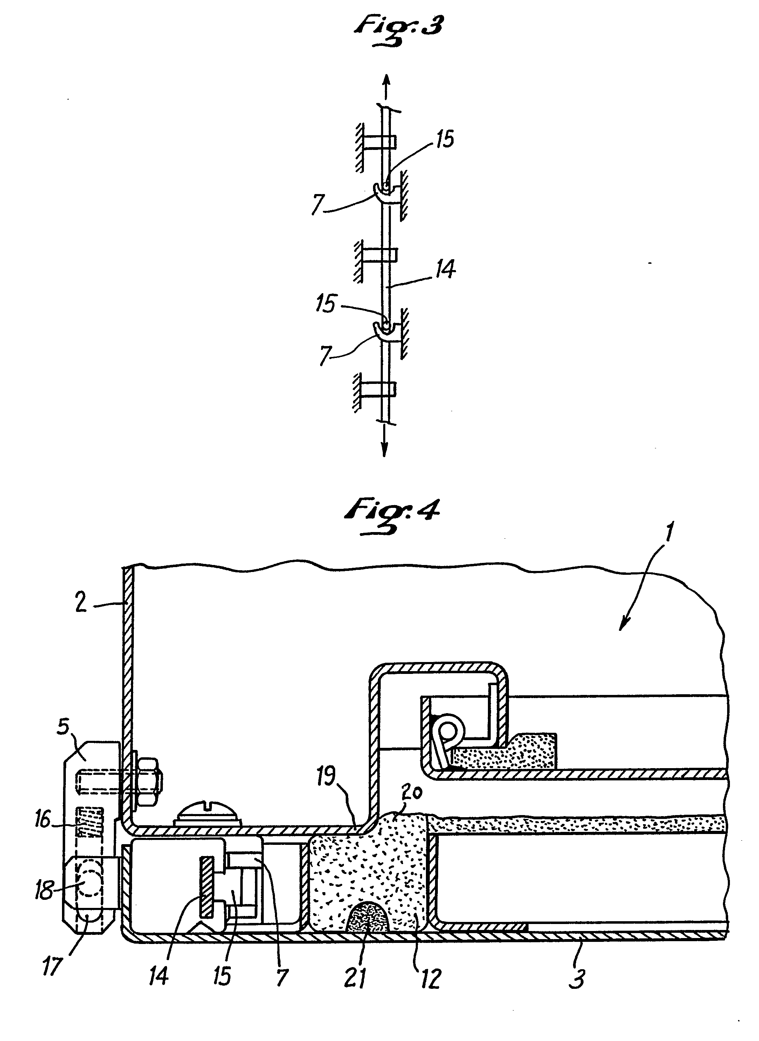

La figure 3 schématise le principe de fonctionnement de la crémone (14) sur laquelle sont disposés des taquets (15) susceptibles d'être engagés lors d'un mouvement longitudinal de la crémone dans des crochets (7) solidaires du châssis. Le mouvement de translation de la crémone (14) permet d'engager simultanément l'ensemble des taquets ou au contraire de les dégager simultanément des crochets (7).

La figure 4 représente la porte (3) vue en coupe pour illustrer le fonctionnement des charnières (5). Comme indiqué précedemment, la porte (3) est plaquée contre le coffre (2) de l'armoire (1) non seulement du côté opposé aux charnières comme cela se rencontre traditionnellement mais également le long du côté sur lequel les charnières (5) prennent appui. Selon l'invention, les charnières (5) autorisent un mouvement de translation de la porte (3) afin que celle-ci puisse venir se plaquer tout le long de l'ouverture de porte. A cette fin, les charnières sont équipées de moyens élastiques (16) aptes à se déformer pour permettre le déplacement. Sur le plan de la fabrication, les charnières comportent des orifices (17) oblongs qui assurent un débattement latéral aux axes de rotation (18). Un ressort (16) s'applique sur l'axe de rotation (18) afin de repousser la porte (3) vers l'extérieur lorsque le double dispositif de fermeture est déverrouillé.

Ainsi, lors de l'opération de fermeture, lorsque la crémone (14) est manoeuvrée, on assiste à un placage de la porte (3) contre le coffre (2) de l'armoire (1), ce qui se traduit par un déplacement de l'axe de rotation (18) dans le trou oblong (17) et une compression du ressort (16).

Les portes sont équipées de moyens d'étanchéité qui se présentent sous la forme d'un joint élastique (12) périphérique. Ce joint continu voit sa surface appliquée partiellement contre un rebord plan (19) du coffre (2) tel qu'illustré à la figure 4. L'absence d'arête vive évite que le joint (12) ne soit entaillé à la longue. Par ailleurs, la pression de contact avec le rebord (19) n'est pas assurée sur toute la surface libre du joint (12) afin que celui-ci puisse librement se déformer dans la zone (20) voisine du rebord (19). Le dégagement (20) qui est laissé pour supporter les déformations du joint (12) comprimé prolonge sa durée de vie et améliore son efficacité par pincement.

Le joint (12) est collé au fond d'une gorge avec un filet de silicone (21) pour renforcer l'étanchéité.

Des précautions doivent cependant être prises pour éviter que, sous la pression de l'eau lorsque l'armoire est immergée, les portes ne puissent se déformer. A cet effet, on dispose des nervures transversales (22) à l'intérieur de la porte (3) telles qu'illustrées à la figure 2. En outre, il faut également veiller que le coffre (2) ne puisse se déformer. En présence de plusieurs portes d'accès (3 et 4), il est souhaitable de disposer des longerons raidisseurs entre le fond du coffre (2) et le montant entre les portes.

Des tests ont été effectués avec l'exemple de réalisation décrit précédemment construit en tôle inox de 2 millimètres d'épaisseur, qui ont permis de montrer une absence totale de pénétration d'eau lors d'une immersion à un mètre au-dessus de l'armoire pendant 48 heures et une présence de 60 millimètres d'eau après 70 heures, ce qui est totalement satisfaisant (Norme NF C 20-010).

D'autres mises en oeuvre de la présente invention, à la portée de l'Homme de l'Art, auraient également pu être envisagées sans pour autant sortir du cadre de celle-ci.

**Revendications**

1. Armoire étanche destinée notamment à contenir du matériel électrique et à le protéger contre une immersion, qui comprend un coffre (2) fermé par une ou plusieurs portes (3 et 4) articulées autour de charnières (5) et munies de moyens d'étanchéité (12) périphérique, **caractérisée** par le fait qu'elle comporte un double dispositif de fermeture (8 et 9) disposé le long des chants latéraux de chacune des portes (3 et 4) qui coopère avec des points d'accrochage (7) répartis autour des ouvertures de porte (3 et 4) sur l'armoire (1).

2. Armoire étanche, selon la revendication 1, **caractérisée** par le fait que le double dispositif de fermeture (8 et 9) se présente sous la forme de deux crémones (13, 14) fixées le long des chants latéraux de la porte (3) sur lesquelles sont régulièrement disposés des moyens d'accrochage (15) au coffre (2).

3. Armoire étanche, selon la revendication 2, **caractérisée** par le fait que les moyens d'accrochage (15) se présentent sous la forme de taquets (15) solidaires de la crémone (14) qui coopèrent avec des crochets (7) fixés sur le coffre (2).

4. Armoire étanche, selon la revendication 1,- **caractérisée** par le fait que les charnières (5) sont équipées de moyens élastiques qui autorisent un mouvement de translation de la porte (3).

5. Armoire étanche, selon la revendication 4, **caractérisée** par le fait que les charnières (5) comportent des orifices oblongs (17) qui assurent un débattement latéral aux axes de rotation (18).

6. Armoire étanche, selon la revendication 5, **ca ractérisée** par le fait qu'un ressort (16) de rappel s'applique sur les axes de rotation (18) pour repousser la porte (3).

7. Armoire étanche, selon la revendication 1, **caractérisée** par le fait que les moyens d'étanchéité (12) se présentent sous la forme d'un joint élastique continu dont la surface est appliquée partiellement contre un rebord plan (19) de telle sorte qu'il subsiste un dégagement (20) apte à supporter les déformations du joint (12) comprimé.

8. Armoire étanche, selon la revendication 7, **caractérisée** par le fait que le joint (12) est collé au fond d'une gorge avec un filet de silicone (21).

9. Armoire étanche, selon la revendication 1, **caractérisée** par le fait que les portes (3 et 4) comportent des nervures transversales (22) pour en limiter les déformations sous l'effort.

10. Armoire étanche, selon la revendication 1, **caractérisée** par le fait que des longerons raidisseurs sont installés entre le fond du coffre (2) et le montant situé entre les portes (3 et 4).

Fig 1

Fig. 2

*Fig:3*

*Fig:4*

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | EP-A-95743 (OY EURAMECANO) <br> * page 5, ligne 22 - page 6, ligne 2; figures 2, 5 * | 1-3, 7 | H05K7/18 |
| | --- | | |
| Y | EP-A-261268 (RAMSAUER) <br> * colonne 4, ligne 30 - colonne 5, ligne 29; figures 1-3, 10 * | 1-3, 7 | |
| | --- | | |
| A | FR-A-1321501 (STERNER) <br> * page 1, colonne de droite, ligne 17 - page 2, colonne de droite, ligne 9; figure 2 * | 4-6 | |
| | ----- | | |

**DOMAINES TECHNIQUES RECHERCHES (Int. Cl.5 )**

H05K
H02B
E05D

Le présent rapport a été établi pour toutes les revendications

| Lieu de la recherche | Date d'achèvement de la recherche | Examinateur |
|---|---|---|
| LA HAYE | 31 JUILLET 1989 | BARANSKI I. |

EPO FORM 1503 03.82 (P0402)